Europäisches Patentamt

European Patent Office

Office européen des brevets

(11) Publication number: 0 486 114 A2

# EUROPEAN PATENT APPLICATION

(21) Application number: **91202975.8**

(51) Int. Cl.⁵: **G01R 31/02**

(22) Date of filing: **15.11.91**

(30) Priority: **16.11.90 GB 9024912**

(43) Date of publication of application:
**20.05.92 Bulletin 92/21**

(84) Designated Contracting States:
**AT BE CH DE DK ES FR GB GR IT LI LU NL SE**

(71) Applicant: **BRITISH AEROSPACE PUBLIC LIMITED COMPANY**
**11 Strand**
**London WC2N 5JT(GB)**

(72) Inventor: **Day, Clive Richard**
**67 Oakleaze Road**
**Thormbury, Nr Bristol BS12 1BP(GB)**

(74) Representative: **Rooney, Paul Blaise et al**
**British Aerospace plc Corporate IPR**
**Department, Headquarters P.O. Box 87**
**Building O191 Royal Aerospace**
**Establishment**
**Farnborough Hants GU14 6YU(GB)**

(54) **Electrical testing apparatus.**

(57) The present invention provides an apparatus (1) for testing an electrical circuit for leakage and continuity losses. It comprises a voltage supply (VHT), a monitor circuit, having a first and second half, a current supply means (2) for supplying an input current ($I_S$, $I_O$) of equal magnitude to each half of the monitor circuit, connection means for connecting a circuit to be tested (3) to the first half of the monitor circuit and current varying means (2). The current varying means (2) is operable to vary the input currents ($I_S$, $I_O$) so as to maintain an output current ($I_R$) from the circuit to be tested constant irrespective of any leakage losses ($I_L$) in the circuit to be tested and to increase the current ($I_O$) in the second half in proportion to the magnitude of the leakage loss (($I_L$). First connection means are provided for connecting a first voltage measuring means across the two halves thereby to determine the magnitude of the leakage loss ($I_L$).

Fig.1.

EP 0 486 114 A2

EP 0 486 114 A2

This invention relates to electrical current measurement and more particularly to electrical current measurement for testing the insulation and continuity of electrical equipment.

It is often found in the test requirements for some equipments that it is necessary to verify that the insulation resistance between one part of an electrical circuit and another part of the same circuit is either within, or outside certain pre-defined limits. Another test requirement often found for the same circuit is that there should be 'Continuity' of electrical connection between two points of the circuit.

These two tests are often applied to electrical circuits such as cable assemblies and unpopulated printed circuit board assemblies. Due to their different requirements, these tests are usually performed separately.

Insulation generally has high resistance values, commonly several megohms. Consequently, high voltages need to be applied to the circuit that is being tested in order to firstly subject the circuit to a voltage at which significant insulation breakdown may occur, and secondly to produce a high, and therefore more easily detectable, leakage current indicative of the quality of the insulation resistance. Insulation testing can be performed with an instrument commonly known as a 'Megger'. This instrument has the capability to produce high voltages, for example, 500V dc, and also a means of detecting current flow due to the applied high voltage. It is important to note that with this instrument that any current flow is considered to be leakage current, and that when testing a perfect insulator, the current flow should always be zero. The output is provided by a current meter usually scaled in units of resistance. With a defined voltage of say 500V dc applied, any leakage current is directly proportional to the insulation resistance from Ohm's law V = IR.

Continuity between two points in a circuit is normally defined, like insulation, in terms of resistance. However, whereas insulation resistances are of the order of Megohms, continuity resistances are usually of fractions of an Ohm. The usual method of measuring such low resistances, is to apply a high current, such as 1 Amp, to the circuit under test. Under these circumstances a continuity resistance of 100 milliohms will produce a voltage difference either end of the conductor of 100 millivolts. This can be easily detected and measured using a digital volt meter. This is most accurately accomplished using what is known as the 'four-wire' configuration.

It can be seen from the previous paragraphs that normally continuity and insulation tests require quite different stimuli and measurement techniques. Insulation testing requires the application of high voltages as stimulus, and a means of detecting small current changes at the output, whereas continuity testing requires the application of high currents as stimulus and a means of detecting small voltage changes at the output.

In some instances it may be necessary to perform these two tests simultaneously, for example, in failure acceleration process testing, or where reduced test times are important.

Due to the conflicting nature of the separate insulation and continuity tests, it is not thought possible to combine the known tests into a single solution using known methods.

According to this invention there is provided an apparatus for testing an electrical circuit, the apparatus comprising:

Voltage supply means; for supplying a voltage and having a high voltage rail and a low voltage rail, characterised by the provision of;

a monitor circuit, having a first and a second half;

current supply means, for supplying an input current of equal magnitude to each half of said monitor circuit;

connection means, for connecting a circuit to be tested to the first half of the monitor circuit;

current varying means, for varying the input current, supplied to the first and second halves of the monitor circuit so as to maintain an output current from the circuit to be tested constant irrespective of any leakage losses in the circuit to be tested and to increase the current in the second half of the monitor circuit in proportion to the magnitude of the leakage loss in the circuit to be tested; and

first connection means for connecting a first voltage measuring means for measuring the voltage across the first and second halves of the monitor circuit thereby to determine the magnitude of the leakage losses in the circuit to be tested.

Preferably, the apparatus includes a second voltage measuring means for measuring the voltage at a point in the first half of the monitor circuit thereby to determine the magnitude of continuity failure in the circuit to be tested.

Advantageously, the apparatus includes prevention means for preventing the connection of a voltage supplied to the first voltage measuring means unless said voltage is within a predetermined range of voltages.

Voltage modifying means may be provided for for modifying a voltage supplied to the first measuring means so as to provide a voltage in direct proportionality to the leakage loss.

2

A high voltage diode may be connected between the output of the current supply means and the circuit to be tested so as to prevent possible damage to the current supply.

A Zener diode may be connected at one end to the voltage supply means and at another end to the second half of the monitor circuit in order to prevent circuit damage.

Advantageously, low pass filters are provided on each of the first and second halves of the monitor circuit in order to reduce the problems associated with induced electrical noise.

Conveniently, a comparator may be connected to the first half of the monitor circuit and operable to change state upon detection of a change in continuity in the circuit to be tested.

Advantageously, a constant current source is connected between the circuit to be tested and a point at which the first voltage measuring means is connected to the first half of the monitor circuit thereby to make the output current from the circuit to be tested and the current in the second half of the monitor circuit substantially immune to variations in the voltage supply from the voltage supply means.

Preferably, the current supply means is a current mirror.

The apparatus may be additionally provided with a first amplifier the inputs of which are connected to the first and second halves of the monitor circuit and the output of which is connected to the gate of a source - follower connected JFET, the drain of said JFET being connected to the output of the current supply means and the high voltage rail of voltage supply and the source of the JFET being connected to the low voltage rail via a resistance across which the first voltage means may be connected for measuring the leakage loss in the circuit to be tested.

Alternatively, the apparatus may be additionally provided with a first amplifier the inputs of which are connected to the first and second halves of the monitor circuit and the output of which is connected to the gate of a source - follower connected JFET, the drain of said JFET being connected to the output of the current supply means and the high voltage rail of the voltage supply and the source of the JFET being connected to the low voltage rail via a second amplifier such that the first voltage means may be connected between the output of said second amplifier and the low voltage rail so as to determine the leakage loss in the circuit to be tested.

For a better understanding of the invention, reference will now be made, by way of example, to the accompanying drawings in which :-

Figure 1 is a circuit diagram showing a configuration for the insulation and continuity testing of a circuit using a PNP current mirror;

Figure 2 is a circuit diagram showing a modified version of the circuit below the line A-A of Figure 1 for determining if a leakage current is within a predetermined range;

Figure 3 is a circuit diagram showing a modified version of the circuit below the line A-A of Figure 1 for providing an output voltage directly proportional to the leakage current;

Figure 4 is a circuit diagram of an improved version of the Figure 3 circuit;

Figure 5 is a circuit diagram showing various modifications to the circuit of Figure 1;

Figure 6 is a circuit diagram showing an alternative embodiment of the Figure 1 circuit using an NPN current mirror; and

Figures 7 and 8 are circuit diagrams showing further alternative embodiments of the Figure 1 circuit where the output is applied to an amplifier.

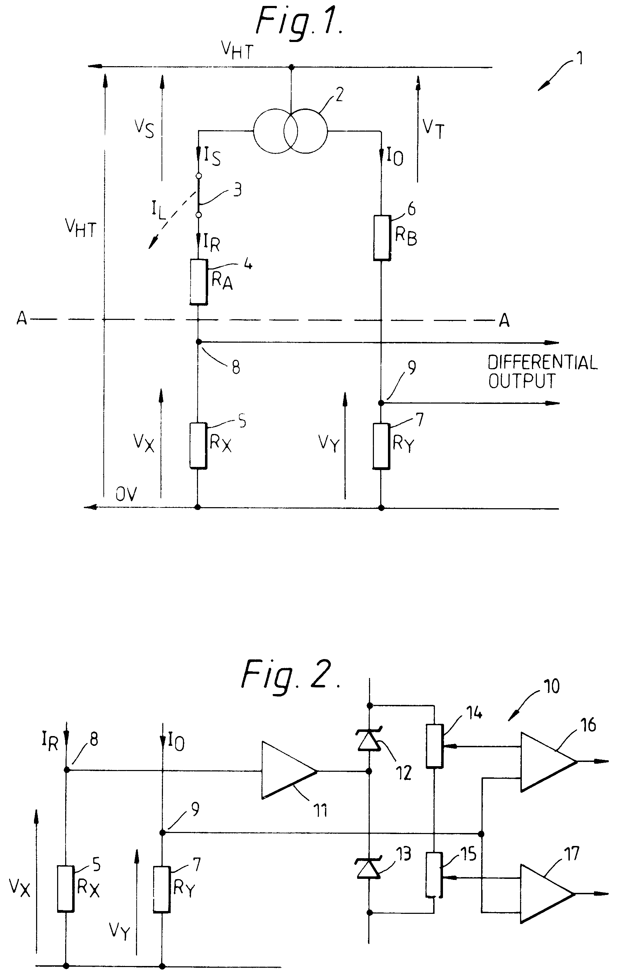

Referring to Figure 1, the circuit shown generally at 1 includes a four-transistor PNP current mirror 2, a description of which can be found in "Current Mirrors, Amplifiers and Dumpers", Wireless World, December 1981 pages 47-50. The current mirror 2 is connected to a high voltage supply having a value $V_{HT}$, and has one input and one output having current values $I_S$ and $I_O$ respectively. The input of the current mirror 2 is connected in series to the input of the circuit under test 3 (shown as a single wire for simplicity). The circuit under test 3 has a leakage current value $I_L$ and an output current value $I_R$. The output of the circuit under test 3 is connected to the O volt return line via resistors 4 and 5 connected in series and having values $R_A$ and $R_X$ respectively. The output of current mirror 2 is also connected to the O volt return line via two resistors 6 and 7 connected in series and having values $R_B$ and $R_Y$ respectively.

The system output, i.e. a representation of leakage current $I_L$, is taken from two terminals 8 and 9 positioned between the series resistor pairs 4, 5 and 6, 7 respectively.

The two resistors 4 and 6 operate as buffer resistors for attenuating the high voltage $V_{HT}$. The value $R_A$ of resistor 4 is chosen to set the value of the bias current $I_S$ from the current mirror. The value $R_B$ of resistor 6 is chosen carefully so that the collector voltage swing of the current mirror output transistor remains within its normal operating parameters for the range of values that the output current may take in response to current leakage.

When the circuit under test 3 has no leakage current, then

$$I_S = I_R = \frac{V_{HT} - V_S}{R_A + R_X} = \frac{V_{HT} - 2V_{be}}{R_A + R_X}$$

where $V_S$ is the voltage drop across the input to current mirror 2 and $V_{be}$ is the base-emitter voltage of the current mirror transistors. Because the voltage $V_{HT}$-$V_S$ is essentially constant and the resistance values $R_A$ and $R_X$ are fixed, the current $I_R$ and the voltage $V_X$ across resistor 5 are both constant. If the resistance values $R_X$ and $R_Y$ are chosen to be identical, then $I_S = I_R = I_O$ and so the voltage $V_Y$ across resistor 7 is identical in value to the voltage $V_X$ and the differential output at the terminals 8 and 9 is 0V

However, if a leakage current $I_L$ is present, the current $I_S$ becomes equal to the sum of currents $I_L$ and $I_R$. Current $I_R$ is essentially constant for all normal conditions and, therefore, the above equation can only be satisfied by an increase in current $I_S$. The operation of the current mirror 2 is such that any increase in current $I_S$ causes an equal increase in current $I_O$. Thus, $I_O$ is no longer equal to $I_R$ and the voltage $V_Y$ across resistor 7 increases by an amount equal to $I_L$x $R_Y$. Because $V_X$ retains its original value, the differential output increases by an amount $I_L$x $R_Y$.

Alternatively, if the leakage current direction is into the circuit under test instead of out of it then $V_Y$ would decrease by the amount $I_L$x $R_Y$.

The circuit 1 is effectively split into two halves. The first half is connected to the input $I_S$ of the current mirror 2 and includes the circuit under test 3, and the second half is connected to the output $I_O$ of the current mirror 2 and provides an output voltage indicative of the leakage current. The two halves are almost independent, being linked only by the current mirror 2. Thus altering parameters in the one half of the circuit will have negligible effect on the other half. For example, it may be desirable to alter the voltage gain and sensitivity of the circuit 1 which is set by the value $R_Y$ of resistor 7. Increasing the value of $R_Y$ will correspondingly increase the sensitivity. This can be advantageous in conditions where the circuit under test is affected by electrical noise, although it will affect the differential output.

Although the circuit has been described with a differential output, i.e. measuring the voltage difference between each half of the circuit 1, it should be appreciated that a single output from terminal 9 could be used. However, the differential output is equal to $I_L$x $R_Y$, and therefore is only dependent on the change of current value $I_L$ (the resistance value $R_Y$ being constant) and not on the bias current $I_S$. The differential output also gives common-mode rejection. Any supply voltage ripple would result in a change of current $I_S$, but this change would be "mirrored" by the current mirror 2 in current $I_O$.Thus, provided $R_X$ is equal to $R_Y$, then the changes in voltages $V_X$ and $V_Y$ will cancel one another out.

Preferably, for optimal operation of the current mirror 2, the ratio of leakage current $I_L$ to bias current $I_S$ is high. Typically, the bias current $I_S$ is chosen to be at least ten times greater than the expected leakage current.

In addition to the insulation testing function, a continuity test may also be performed by measuring the voltage $V_X$ at terminal 8. For a total continuity failure, $V_X$ would fall to OV as would $V_Y$. A partial continuity failure would result in a reduction of current $I_R$ and voltage $V_X$, the amount of reduction being dependent of the ratio of the effective continuity resistance of the test circuit 3 to the value $R_A$ of resistor 4. It should be noted that a partial continuity failure will result in change in current $I_S$ which will be "mirrored" by the current mirror 2 in current $I_O$, hence the differential voltage output, which represents leakage current, will not change. Thus, the circuit 1 clearly establishes whether change in output at terminals 8 and 9 is due to a continuity or insulation failure condition.

Although this circuit is effective at measuring leakage currents, the accuracy of the circuit decreases for large values of the supply voltage $V_{HT}$. When a leakage current $I_L$ is present, the circuit is unbalanced because $I_O$ differs from $I_R$ by an amount equal to the leakage current $I_L$. Thus, the collector voltage $V_T$ of the output transistor of the current mirror 2 is dependent on the value of the leakage current $I_L$ and the value of resistor $R_B$. This is only a significant problem at higher supply voltages $V_{HT}$ as the value of $R_B$ is set to be higher and therefore the collector voltage swing $V_T$ is greater for the same value of leakage current $I_L$.

Referring to Figure 2, a circuit adapted for testing if the leakage current is within a predetermined range is shown generally at 10. This circuit includes all the components of the circuit of Figure 1 above the line A-A and is modified below this line as shown. This circuit is operable for determining whether the leakage current is outside a predetermined value. The basic circuit is the same as that of Figure 1. However, the output from the terminal 8 is connected to voltage buffer 11, the output of which is in turn connected in parallel to two diodes 12 and 13. These diodes set the limits of the positive and negative voltage which is to be measured. The value range for which the circuit will produce an output is adjusted between these values by two potentiometers 14 and 15 connected in parallel across the diode pair 12 and 13. Output terminal 9 is connected to the input of each of two comparators 16 and 17, while the reference voltage input of each of the two comparators is supplied by the output of respective potentiometers 14 and 15. By choosing appropriate values for the two resistors 5 and 7 and for the two potentiometers 14 and 15 a voltage "window" can be set in which the comparators give an output indicative of a leakage current. The window may be simply changed in size by adjusting each of the two potentiometers 14 and 15.

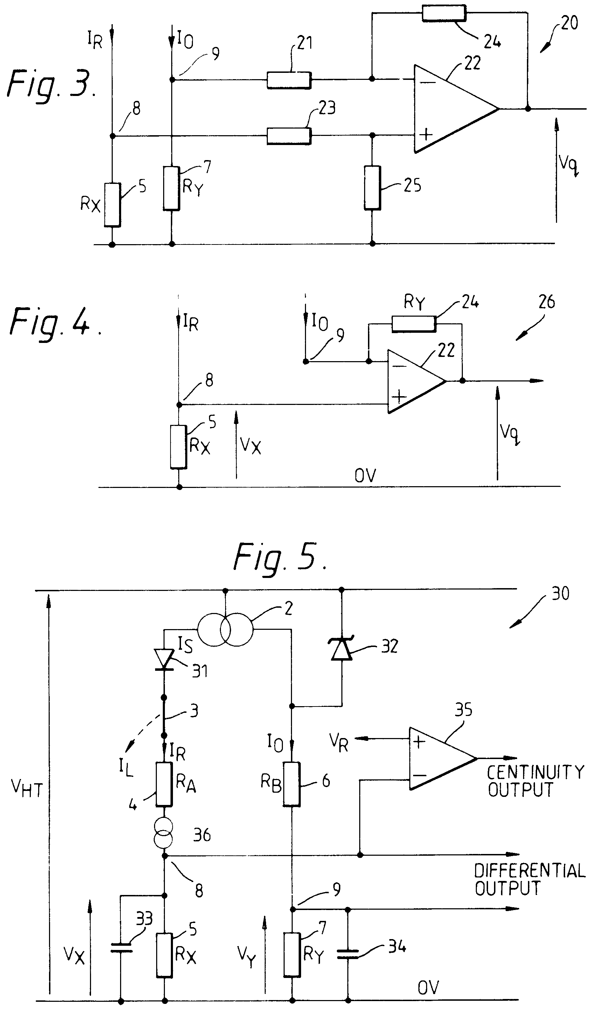

Referring to Figure 3, a circuit adapted to give an output directly proportional to the leakage current is shown generally at 20. This circuit includes all the components of the circuit shown in Figure 1 above the line A-A and is modified below this line as shown. The basic circuit is again the same as that of Figure 1. However, output terminal 8 is connected, via resistor 21, to the non-inverting input of a differential amplifier 22, and the output terminal 9 is connected, via resistor 23, to the inverting input of differential amplifier 22 in order to produce an output voltage Vq which is directly proportional to the leakage current i.e.,

$$Vq = I_L.R_L$$

where is the gain of the differential stage. The resistors 5, 7, 21, 23, 24 and 25 must be matched to provide common-mode rejection.

A circuit having an equivalent function to that of the circuit 20 is shown in Figure 4 at 26. The circuit uses fewer components - resistors 7, 21, 23 and 25 are dispensed with - and, provided the value $R_X$ of resistor 5 and the value $R_Y$ of resistor 24 are matched the circuit will give common mode rejection. Under no leakage current conditions, the voltage $V_q$ is essentially zero.

Referring to Figure 5, a modified version of the circuit of Figure 1 is shown at 30.

The first modification consists of a high-voltage diode 31 inserted between the input of the current mirror 2 and the circuit under test 3. This modification is desirable when, for example, the test circuit consists of several cable wires which are tested simultaneously and in which there is a short circuit fault between two or more wires that are at a different potential to one another. If the diode 31 was not present, then the input transistor of the current mirror, when at the lowest potential, may be reverse biased thus possibly destroying it. However the inclusion of the diode 31 will reduce the voltage on the circuit under test by one Vbe (the base-emitter voltage of the current mirror transistors). The value of Vbe is essentially constant for a wide range of values for the current $I_S$, but can be compensated for, if necessary, by an increase of applied voltage $V_{HT}$.

The second modification consists of a Zener diode 32 placed between the current mirror input $I_O$ and the high voltage supply $V_{HT}$. The Zener diode 32 has a value chosen to be near the breakdown voltage of the output transistor of the current mirror 2. This modification is desirable when a continuity failure occurs in the circuit under test 3 because this causes the current mirror 2 currents $I_S$ and $I_O$ to fall to essentially zero. This would cause the output transistor of the current mirror to cut-off and, if the applied voltage is greater than the transistor collector breakdown voltage, then the output transistor could be destroyed. The Zener diode 32 provides an alternative electrical path that conducts before the collector voltage reaches its breakdown value. In some applications the Zener diode 32 could be replaced by a resistor. However, this may result in a significant error in the value of current $I_O$ - much larger than the relatively small error caused by the Zener diode 32.

The third modification consists of two capacitors 33 and 34. Capacitor 33 is inserted in parallel across resistor 5 and Capacitor 34 is inserted in parallel across resistor 7. The capacitors 33 and 34 act as low pass filters on the two output terminals 8 and 9. The values of the capacitors required depend on the values $R_A$, $R_B$ of the two resistors 4 and 6 and should ideally be selected such that the values of resistor 4 and capacitor 33 have an equal time constant to resistor 6 and capacitor 34. The inclusion of the capacitors reduce the problems associated with induced electrical noise in the circuit under test 3 without the problems associated with changing the value of $R_Y$ of resistor 7. Many other filtering methods could equally well be used.

The fourth modification consists of connecting the inverting input of a comparator 35 to the continuity detector output from terminal 8 and connecting the reference voltage input to a constant voltage supply having a value $V_R$ which is between OV and the voltage $V_X$ under normal continuity conditions. If a discontinuity occurs in the circuit under test 3 then the current $I_S$ falls to zero as does $V_X$. The comparator 35 will respond to this by changing state. Thus, the comparator 35 provides a simple continuity check performed on the circuit under test 3 at the same time as the insulation test. The circuit does not monitor continuity in terms of absolute resistance but it does perform a simple open-circuit/short-circuit check which in many situations is sufficient. The sensitivity is set by the voltage difference at the comparator inputs. In order that the comparator 35 does not change state due to noise or other unwanted signals, the sensitivity should be set low by making $V_R$ at least several hundred millivolts less that $V_X$.

A fifth modification consists of a constant current source 36, having a constant current output equal to $I_R$, which replaces the link between resistor 4 and terminal 8. The constant current source 36 has the effect of making the currents $I_R$, and therefore $I_O$, virtually immune from any variations of the high voltage supply $V_{HT}$. The bias current is set by the current source - rather than by the high voltage supply and the value $R_A$ of resistor 4 as in previously described embodiments. Although this modification reduces the effects of variations in the power supply on the accuracy of the leakage current detector and the continuity detector, this is achieved at the expense of the sensitivity of the continuity detector. This modification is desirable in those cases where the accuracy of the leakage current measurement is more important than the sensitivity of the continuity detector.

It should be understood that although the five modifications described above are all shown together in Figure 5 they may be used individually or in any combination with the basic circuit design shown in Figure 1.

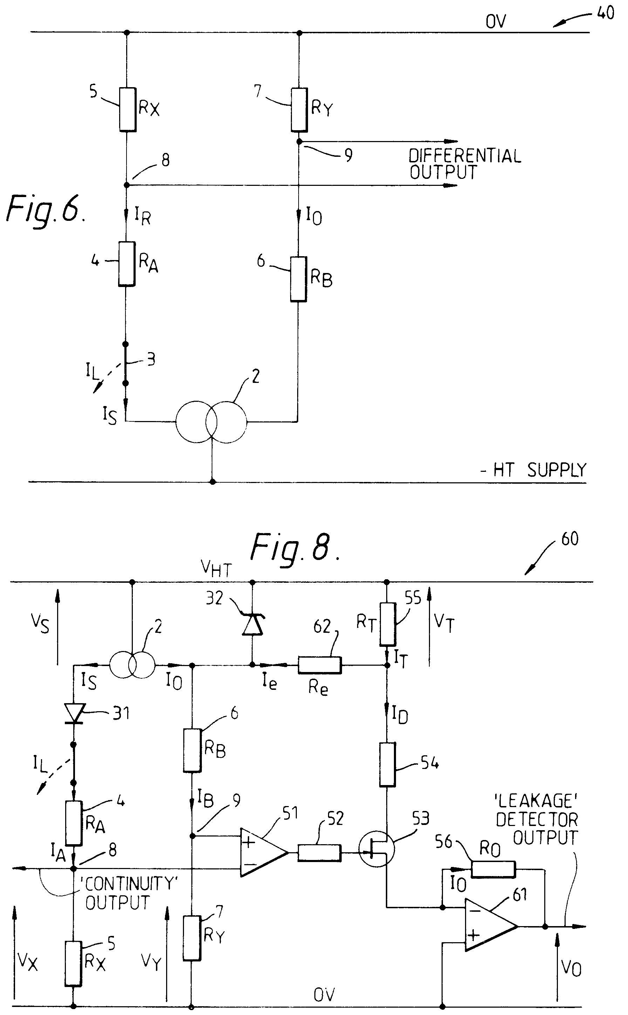

Figure 6 shows an alternative embodiment of the invention. The circuit, shown generally at 40, is effectively an inversion of the Figure 1 circuit - the high voltage supply is now negative with respect to OV and the current mirror is a four transistor NPN type (rather that a PNP type). This circuit configuration may be preferable because NPN current mirrors are available in 'chip' form (for example, the Burr Brown REF 200) and, furthermore, NPN current mirrors may have a more accurate operation than the PNP type.

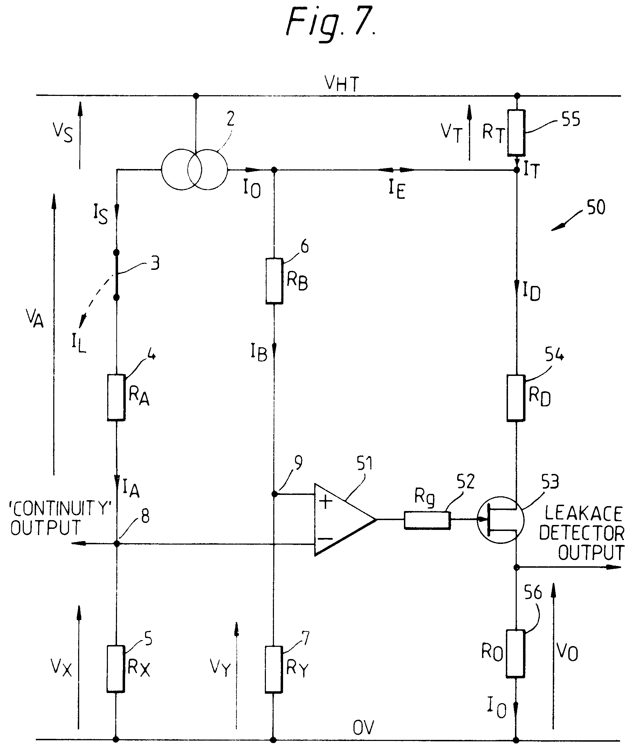

Figure 7 shows a further embodiment of the invention. The circuit, shown generally at 50, overcomes the problem of inaccuracy when used with high supply voltages as previously described in relation to Figure 1. The basic circuit is the same as that of Figure 1. Terminals 8 and 9 are connected to the inverting and non-inverting inputs of amplifier 51 respectively. The output of amplifier 51 is applied, via a resistor 52, to the gate of a source - follower connected JFET 53. The output of the current mirror 2 is connected to the drain of the JFET 53 via a resistor 54. The high voltage source $V_{HT}$ is also applied to the drain of the JFET 53 via two resistors 54 and 55, the latter having a resistance value RD. The source of JFET 53 is connected to the OV supply rail via a resistor 56 (value $R_O$) across which the voltage $V_O$ (representing leakage current $I_L$) can be measured.

The values of resistors $R_X$ and $R_Y$ are selected as before, but the values $R_A$ and $R_B$ are not as critical as they were in the circuit of Figure 1, although they must have equal values selected to ensure the current mirror 2 operates well within its range.

The problem of inaccuracy at high voltages is overcome by balancing the circuit for all values of leakage current $I_L$ by the action of the amplifier 51 which, according to the value of its inputs from terminals 8 and 9, controls the JFET 53 which ensures the value of current $I_e$ is equal of the leakage current $I_L$. The voltage (value $V_T$) across resistor 55 is the same as the voltage drop $V_S$ across the current mirror 3 and is essentially constant which provides a constant current (value $I_T$ that is combined with current $I_e$. The circuit operates effectively by adding or subtracting current $I_e$ from the constant current $I_T$. Thus, under no leakage conditions, the output voltage $V_o = I_T \times R_O$ and, under leakage conditions, the change in output voltage $V_o = I_e \times R_O$.

The value of resistor $R_O$ sets the sensitivity of the circuit, and can simply be adjusted without affecting the common mode rejection quality of output.

Figure 8 shows yet a further embodiment of the invention. The circuit shown generally at 60, is based on the circuit of Figure 7. The circuits differ in the following ways. The source of the source-follower 53 is connected to the inverting input of amplifier 61, while the non-inverting input is connected to the OV supply line. The inverting input and the output of amplifier 61 are connected by means of a resistor 56 (value $R_O$). The configuration ensures that the gate voltage of the JFET 53 is always maintained within the output voltage range of amplifier 51, assuming the JFET 53 has a fairly low 'pinch-off' voltage. The circuit of Figure 8 also includes diodes 31 and 32 which operates in the same way as their identically labelled counterparts described in relation to Figure 5. The diode 31 adds approximately 0.6v to the value of $V_T$. This can, however, be compensated for by a suitable increase in the value of $R_B$. Another modification to the circuit is the inclusion of resistor 62 (value Re). This resistor is included to add current gain to the circuit which provides an alternative method of controlling the output gain of the circuit. The output voltage is now given by

$$V_O = \frac{R_O \ (1.4\pm \ (I_e \ (R_T + R_e)))}{R_T}$$

Where the constant 1.4 is approximately twice the base emitter voltage of the current mirror transistors, when diode 31 is not included, and will be nearer 2 when the diode is included, for the conditions where $R_A = R_B$. Under no leakage conditions this reduces to

$$V_O = \frac{1.4 \ R_O}{R_T}$$

This allows separate adjustment of the quiescent output voltage by adjustment of $R_T$ and setting the sensitivity by adjustment of $R_e$.

It should be noted that although the embodiments of the circuit described herein all refer to the use of a four-transistor current mirror, a two or three transistor current mirror may also be used, but with reduced accuracy.

It should also be understood that while the embodiments described relate to insulation testing, the principle may equally be suitable for other purposes such as bare board testing of printed circuit boards.

**Claims**

1.  An apparatus (1) for testing an electrical circuit, the apparatus comprising:

    Voltage supply means (VHT); for supplying a voltage and having a high voltage rail and a low voltage rail, characterised by the provision of;

    a monitor circuit, having a first and a second half;

    current supply means (2), for supplying an input current $(I_S)(I_O)$ of equal magnitude to each half of said monitor circuit;

    connection means, for connecting a circuit to be tested (3) to the first half of the monitor circuit;

    current varying means (2), for varying the input current $(I_S, I_O)$ supplied to the first and second halves of the monitor circuit so as to maintain an output current $(I_R)$ from the circuit to be tested (3) constant irrespective of any leakage losses $(I_L)$ in the circuit to be tested and to increase the current $(I_O)$ in the second half of the monitor circuit in proportion to the magnitude of the leakage loss $(I_L)$ in the circuit to be tested; and

    first connection means for connecting a first voltage measuring means to the monitor circuit for measuring the voltage across the first and second halves of the monitor circuit $(V_Y -V_X)$ thereby to determine the magnitude of the leakage losses $(I_L)$ in the circuit to be tested (3).

2.  An apparatus as claimed in claim 1 including second voltage measuring means for measuring the voltage $(V_Y)$ at a point in the first half of the monitor circuit thereby to determine the magnitude of continuity failure in the circuit to be tested.

3.  An apparatus as claimed in claim 1 or claim 2 including prevention means (10) for preventing the connection of a voltage supplied to the first voltage measuring means unless said voltage is within a predetermined range of voltages.

4.  An apparatus as claimed in any one of the preceding claims including voltage modifying means (20) for modifying a voltage supplied to the first measuring means so as to provide a voltage in direct proportionality to the leakage loss.

5.  An apparatus as claimed in any one of the preceding claims including a high voltage diode (31) positioned between the output $(I_S)$ of the current supply means and the circuit to be tested (3).

6. An apparatus as claimed in any one of the preceding claims, including a diode (32) connected at one end to the voltage supply means (VHT) and at another end to the second half of the monitor circuit.

7. An apparatus as claimed in any one of the preceding claims including low pass filters (33, 34) on each of the first and second halves of the monitor circuit.

8. An apparatus as claimed in any one of the preceding claims including a comparator (35) connected to the first half of the monitor circuit and operable to change states upon detection of a change in continuity in the circuit to be tested (3).

9. An apparatus as claimed in any one of the preceding claims including a constant current source (36) connected between the circuit to be tested (3) and a point at which the first voltage measuring means is connected to the first half of the monitor circuit thereby to make the output current from the circuit to be tested (3) and the current in the second half of the monitor circuit substantially immune to variations in the voltage supply from the voltage supply means.

10. An apparatus as claimed in any one of the preceding claims in which the current supply means (2) is a current mirror.

11. An apparatus as claimed in any one of the preceding claims including a first amplifier (51) the inputs of which are connected to the first and second halves of the monitor circuit and the output of which is connected to the gate of a source - follower connected JFET (53), the drain of said JFET being connected to the output of the current supply means and the high voltage rail (VHT) of voltage supply and the source of the JFET being connected to the low voltage rail ($O_V$) via a resistance ($R_O$) across which the first voltage means may be connected for measuring the leakage loss in the circuit to be tested.

12. An apparatus as claimed in any one of claims 1 to 10 including a first amplifier (51) the inputs of which are connected to the first and second halves of the monitor circuit and the output of which is connected to the gate of a source - follower connected JFET (53), the drain of said JFET being connected to the output of the current supply means and the high voltage rail of the voltage supply and the source of the JFET being connected to the low voltage rail via a second amplifier (61) such that the first voltage means may be connected between the output of said second amplifier and the low voltage rail so as to determine the leakage loss in the circuit to be tested.

Fig.1.

Fig.2.

Fig. 3.

Fig. 4.

Fig. 5.

Fig.6.

DIFFERENTIAL
OUTPUT

OV

40

$I_R$

$I_0$

5 $R_X$

7 $R_Y$

8

9

4 $R_A$

6 $R_B$

$I_L$ 3

$I_S$

2

– HT SUPPLY

Fig.8.

60

$V_{HT}$

$V_S$

32

$R_T$ 55

$V_T$

$I_S$

2

$I_0$

$I_e$

$R_e$ 62

$I_T$

31

$I_L$

$R_B$ 6

$I_D$

4 $R_A$

54

$I_A$ 8

$I_B$ 9

51

52

53

'LEAKAGE'
DETECTOR
OUTPUT

'CONTINUITY'
OUTPUT

56 $R_0$

$I_0$

61

$V_X$

5 $R_X$

$V_Y$

7 $R_Y$

$V_0$

OV

11

# Fig.7.